# EUROPEAN PATENT SPECIFICATION

(11) **EP 1 779 481 B1**
(45) Date of publication and mention of the grant of the patent: **21.08.2019**
(21) Application number: 05762327.4
(22) Date of filing: 17.06.2005
(51) Int. Cl.: G01B 9/02, H01S 3/22, G02B 5/04, G03F 7/20

(54) **METHOD AND APPARATUS FOR GAS DISCHARGE LASER OUTPUT LIGHT COHERENCY REDUCTION**
VERFAHREN UND VORRICHTUNG ZUR REDUKTION DER AUSGANGSLICHTKOHÄRENZ EINES GASENTLADUNGSLASERS
PROCEDE ET DISPOSITIF DE REDUCTION DE COHERENCE POUR LA LUMIERE EMISE PAR UN LASER A DECHARGE GAZEUSE

(30) Priority: 29.06.2004 US 881533
(43) Date of publication of application: 02.05.2007
(73) Proprietor: Cymer, LLC, San Diego, CA 92127-2413 (US)
(72) Inventor: RAFAC, Robert, J., Encinitas, CA 92009 (US); SMITH, Scot, T., Winter Springs, FL 32708 (US)
(74) Representative: Grünecker Patent- und Rechtsanwälte PartG mbB
(86) International application number: PCT/US2005/021576
(87) International publication number: WO 2006/012062

(56) References cited:
- US-A- 5 127 731
- US-A- 5 130 994
- US-A- 5 457 706
- US-A1- 2003 016 363
- US-A1- 2003 161 374
- US-A1- 2003 161 374
- US-A1- 2004 109 166
- US-B1- 6 351 296
- LOWENTHAL S ET AL: "SPECKLE REMOVAL BY A SLOWLY MOVING DIFFUSER ASSOCIATED WITH A MOTIONLESS DIFFUSER", JOURNAL OF THE OPTICAL SOCIETY OF AMERICA, AMERICAN INSTITUTE OF PHYSICS, NEW YORK; US, vol. 61, no. 7, 1 July 1971 (1971-07-01), pages 847-851, XP001118490, ISSN: 0093-5433, DOI: 10.1364/JOSA.61.000847

## Description

### FIELD OF THE INVENTION

The invention relates to a gas discharge laser outputting a laser beam comprising output laser light pulses, for delivery as a light source to a utilizing tool.

### BACKGROUND OF THE INVENTION

Applicants have discovered that vertical symmetry can be a problem with certain laser light sources, e.g., gas discharge laser lithography light sources, e.g., XLA series lasers sold by applicants' assignee Cymer, Inc. for use in integrated circuit lithography. The vertical profile centroid may shift depending on laser operating conditions. Also at issue in such light sources is beam coherence.

The use of a spinning diffuser for spatial coherence destruction is a common technique for certain applications where spatial coherence is undesirable, though applicants are not aware of its use as applied in the present application, since applicants believe they are the first to discover the nature of the problem impacting, e.g., the high speed measurement of spectral energy integration values for high repetition rate pulsed narrow band gas discharge lasers utilizing, e.g., fringe width measurements at some selected width at some selected percentage of the peak value, e.g., full width at half the maximum ("FWHM") with accuracies required in the tens of femtometers at repetition rates in the thousands of pulses per second, e.g., at and well above 2000 pulses per second, applicants have determined that such measurements, i.e., FWHM and the like are adversely affected by speckle ot these dimensions of the FWHM measurements.

The requirements from integrators of laser light sources into steppers and scanners and like lithography tools are ever continuing to tighten, and next generation laser light sources, e.g., will have to address a variety of operational requirements to meet the customer demands, e.g., in the operation of the wavemeters, e.g., at higher speeds for pulse to pulse measurements or some acceptable substitute that trades accuracy for pulse to pulse measurement and with the greater accuracy and consistency required, e.g., for accurate E95 measurements at the tens of femtometer levels.

Pulse stretchers are known in the art, e.g., as disclosed in United States Patent No. 6,535,531. United States Patent No. 6,480,275 shows a etalon/grating based monochromator used for spectrometry.

Further, US 2003/016363 A1 discloses a gas discharge ultraviolet laser source with an internal wavemeter using having a spectrometer with an etalon. The beampath leading to the spectrometer comprises a beam homogenizer employing an arrangement of two stationary diffusers.

The paper of Lowenthal, S., et.al., entitled "Speckle Removal by a slowly moving Diffuser associated with a motionless Diffuser", Journal of the Optical Society of America, American Institute of Physics, New York, US, vol. 61, no. 7, 1 July 1971, pages 847 - 851, teaches in a general manner the reduction of speckles in an arrangement where a beam travels through a motionless diffuser followed by a slowly moving diffuser.

### SUMMARY OF THE INVENTION

The present invention provides a high repetition rate gas discharge laser according to claim 1.

The homogenizer may further comprise a pair of conjoined dove prisms having a partially reflective coating at the conjoined surfaces of each,
a right triangle prism comprising a hypotenuse face facing the source beam and fully reflective adjoining side faces or an isosceles triangle prism having a face facing the source beam and fully reflective adjoining side faces or combinations of these, which may serve as a source beam multiple alternating inverted image creating mechanism. The beam path is part of a bandwidth detector measuring the bandwidths of an output laser beam comprising output laser light in the range of below 500 femtometers at accuracies within tens of femtometers. The homogenizer comprises the rotating diffuser which may be a ground glass diffuser which may also be etched. The wavemeter also comprises a collimator in the beam path collimating the diffused light; a confocal etalon
creating an output based upon the collimated light entering the confocal etalon; and a detector detecting the output of the confocal etalon. The detector may also comprise a scanning mechanism scanning the angle of incidence of the collimated light entering the confocal etalon which may scan the collimated light across the confocal etalon or scan the etalon across the collimated light, and may comprise an acousto-optical scanner. The confocal etalon may have a free spectral range approximately equal to the E95 width of the input source spectrum to be measured. The detector may comprise a photomultiplier detecting an intensity pattern of the output of the confocal etalon.

### BRIEF DESCRIPTION OF THE DRAWINGS

FIG. 1 shows schematically one possible optical arrangement;
FIG. 2 shows schematically another possible optical arrangement
FIG. 3 shows schematically another possible optical arrangement
FIG. 4 shows schematically a wavemeter according to an embodiment of the present invention;
FIG. 5 shows a wavemeter useful with aspects of an embodiment of the present invention;
FIG.' s 5B1-B7 shows schematically aspects of the operation of a wavementer according to FIG. 5;
FIG. 5 C show aspects of a detector useful in a wavemeter according to FIG. 5;
FIG. 6 shows a plot of deviations of FWHM measurements from an expected function without the utilization of aspects of an embodiment of the present invention;
FIG. 7 shows a plot of the resulting improvement in the FWHM deviation according to aspects of an embodiment of the present invention;
FIG. 8 shows a plot indicating the capabilities for reduction in speckle noise according to aspects of an embodiment of the present invention;
FIG. 9 shows schematically a wavemeter according to aspects of an embodiment of the present invention; FIG. 10 shows schematically another form of aspects of the embodiment of the present invention illustrated in FIG. 9; and
FIG. 11 shows an illustration of the manner of resolving bandwidth according to aspects of an embodiment of the present invention.

### DETAILED DESCRIPTION OF PREFERRED EMBODIMENTS

To alleviate the problem of loss of beam symmetry, e.g., vertical symmetry, e.g., where the vertical centroid tends to shift, applicants propose, e.g., the use of any of a variety of multiple optical schemes that can produce alternating inverted images of the beam. Applicants believe that such schemes will not only positively affect beam profile symmetry but also have a beneficial impact on the spatial coherence of the beam, since by there intrinsic behavior such optics can, e.g., shift the position of coherence cells.

Upon examination it was discovered by applicants in the testing of the properties of a 100ns optical pulse stretcher ("OPuS") as discussed in the above reference co-pending patent applications also assigned to applicants' assignee, that beam symmetry can be improved when optics such as those contained in an OPuS module are inserted into the laser output beam path. This effect was attributed by applicants to the imaging characteristics of, e.g., the optics in the 100ns OPuS.

Also noted by applicants was that, e.g., if a pulse stretcher contained an odd number of image relays it would create an inverted image of the input beam. Since the entire pulse stretcher creates a pulse train from an original input pulse, each sub-pulse will be an inverted image from the previous sub-pulse. Therefore, the original input beam pulses will be converted into a series of sub-pulses whose beam profiles will have alternating inverted images. Applicants propose to employ such concepts to other optical laser problems, especially in applications where the delay paths needed for pulse stretching per se are not needed or desired, e.g., more compact and simple optical designs can be created if the purpose is, e.g., for homogenization and not for pulse length extension.

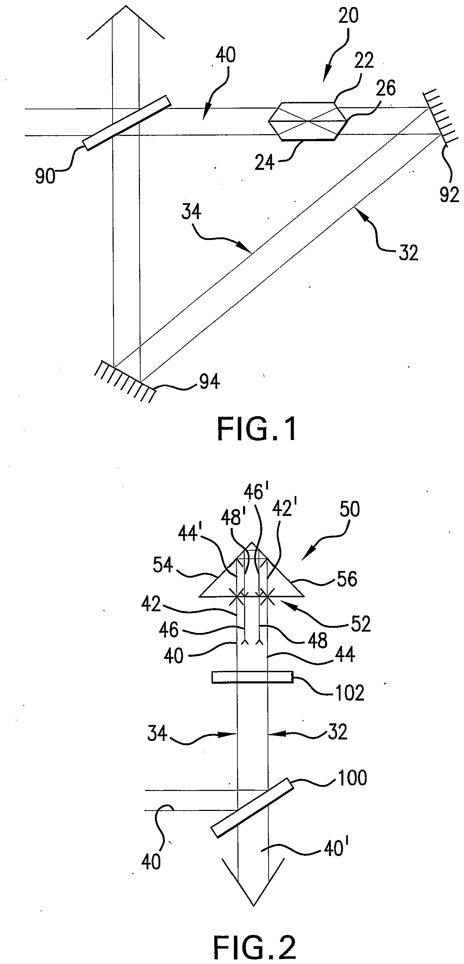

Turning now to FIG. 1, one possible optical arrangement is shown which could involve a prism 20 which can be constructed, e.g., from two dove prisms 22, 24. The two prisms 22, 24 can be connected at their respective bases 26 with a partial reflective coating between them, thereby forming conjoined dove prisms having a partially reflecting coating at the conjoined surfaces of each. The prisms 22, 24 could then produce two beams 32, 34 from the original input beam 40 as shown schematically in FIG. 1. One beam, e.g., 32 would be the same orientation of the input beam 40 and the other 34 would be inverted. If the prism 20 were rotated, e.g., by 45 degrees about its optical axis, it would produce an inverted beam and a 90 degree rotated beam from the original beam 40. This particular design could be inserted into optical path of the beam 40 and would not deviate the beam 40.

Turning now to FIG. 2 there is shown schematically another possible arrangement wherein, e.g., a right triangle prism 50 can be used. The prism 50 could have a partial reflective coating on its base 52 formed by its hypotenuse face and, e.g., utilize a total internal reflective property of the prism or have full reflective coatings along its sides 54, 56. Unlike the dove prism 20 design, the arrangement shown schematically in FIG. 2 could be capable of producing multiple alternating inverted images, as is shown schematically in FIG. 2, e.g., where ray 42 is partially reflected on itself and also becomes ray 42'and similarly for rays 44, 44', 46, 46' and 48, 48'.

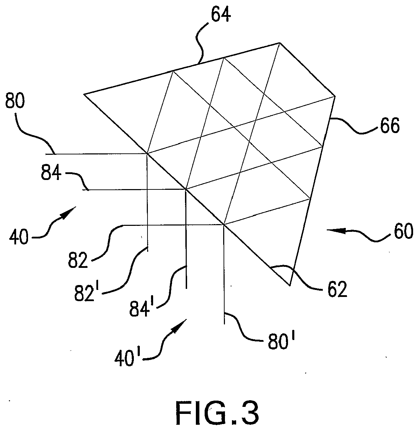

A further modification thereof involving, e.g., an isosceles triangle prism 60 is shown schematically in FIG. 3. Multiple images would be produced because of the re-circulating nature of the prism 60 produced by recombining the inverted image at a partial reflector as was the case for the right triangle prism 50, such that ray 80 from the incoming beam 40 becomes ray 80' emerging on the opposite side of the output beam 40' rotated through 90 degrees from the input beam 40 and ray 82 becomes ray 82' and ray 84 becomes ray 84', with ray 82' being on the partially reflected ray formed by ray 80 and ray 80' being on the partially reflected ray formed by ray 82 and ray 84' being on its own partially reflected ray formed by ray 84. Internal partial reflections from the hypotenuse face 62 create further inversions of the beam.

Since the isosceles prism 60 design redirects the beam 40 through a 90 degree angle it may advantageously be suited for utilization in a position where such a 90 degree turn is already performed by existing optics, e.g., in a laser system, e.g., in a master oscillator power amplifier ("MOPA") or other possible variations, e.g., a master oscillator power oscillator ("MOPO") or a power oscillator power oscillator ("POPO") configuration relay optics arrangement between, e.g., the exit from the MO and the entrance to the PA, whether that be hi the same or different laser gas medium chambers. This may be implemented, e.g. in a so-called wave engineering box ("WEB") currently in use in applicants' assignee's XLA series MOPA configured lasers, such as the turning prism in the MO WEB between the MO chamber and the PA chamber, hi this orientation, the prism 60 could be capable of producing alternating inverted images of, e.g., the vertical axis. Also, since the plane of incidence could be in the S plane with respect to the incoming beam 40, the design of the full reflective coatings could be more simple.

Since the prism 60 inverts the beam about the center of the input face, the re-circulating beam will be offset from the input beam by twice the amount that the input beam is offset from the center of the prism 60. The effect of the right triangle prism 50 or isosceles prism 60 can be achieved with the use of individual optical components comprising, e.g., two mirrors and a beam splitter, also providing the means to combine both the homogenizing effects of the dove prism 40 design and the right triangle 50 or isosceles prism 60 design.

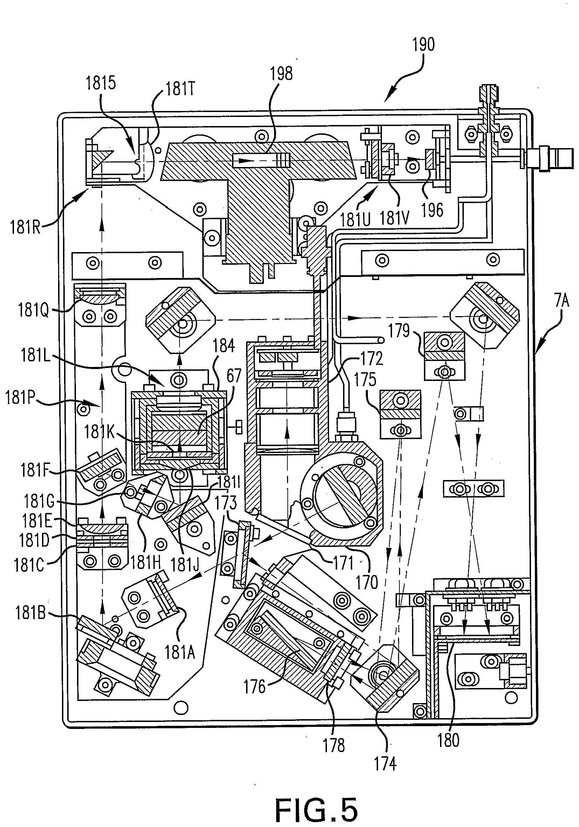

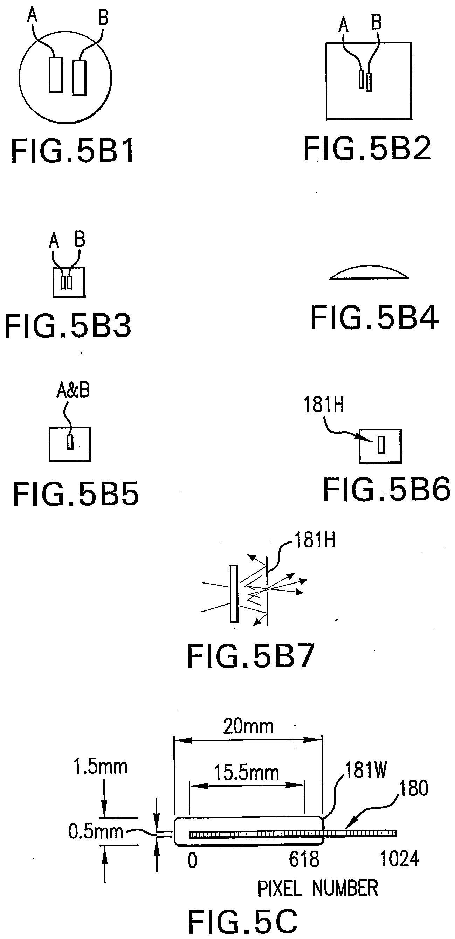

The above noted arrangements can be beneficially applied in the field of bandwidth measurement, e.g., utilizing wavemeters known from US 2003/0016363 A1.. Other application can include any form of spectrometry using, e.g., dispersive optics such as etalons or diffractive optics such as gratings, e.g., eschelle gratings as is well known in the art of spectrometry. Applicants have found that a key contributor to, e.g., poor bandwidth tracking can be speckle noise. Additionally, the elimination of spatial coherence as discussed above can be used to reduce speckle noise and thereby applicants have found a way of significantly improving, spectrometry, e.g., for bandwidth tracking. Removal of the adverse effects of, e.g., speckle, has positive implications for the measurement of the bandwidth at some percentage of the peak energy (intensity), e.g., at the half maximum points on the spectrum, so-called full width half max ("FWHM"). Consequently, techniques for estimating integral energy measurements of bandwidth, e.g., the energy integrated to include 955 of the energy about the spectral peak ("E95") from measurements of, e.g., FWHM at the dimensions of FWHM which are discussed in the present application and required by present integrated circuit manufacturing specifications can also be greatly improved by the elimination or lessening of the adverse effects of speckle noise. These aspects of embodiments of the present invention can be useful in so-called on-board wavemeters in measuring, e.g., bandwidth as exemplified by the wavemeter of FIG. 5, for testing of, e.g., laser beam parameters such as bandwidth, e.g., in the field or during manufacture and even for calibrating wavemeters of other forms of bandwidth or center wavelength detectors, e.g., spectrometers, e.g., grating
spectrometers using, e.g., a solid state laser with a 193nm center wavelength or a harmonically multiplied Argon-ion laser for 248 nm.

Therefore arrangements as discussed above can be useful for reduction of speckle noise and enhancement of the ability to more accurately and consistently track bandwidth and has the advantage of not requiring moving parts such as would be required with, e.g., a spinning diffuser as discussed in more detail below, with the resultant avoidance of a component subject to wear and tear and to possibly producing undesirable effects, such as vibration. Advantageously arrangements as discussed above can be used to alter the coherence cells within the laser beam to reduce its spatial coherence and reduce the speckle noise component, e.g., in the laser output beam and/or in a portion of the beam selected for analysis, e.g., in an etalon spectrometer 190 as shown in FIG. 5.

As discussed above, the arrangements of FIG.' s 1-3 can be somewhat similar to a pulse stretcher, in that there could be a beam splitter 90 used to divert and recombine a portion of the beam 40 through a delay line containing, e.g., a prism 20, 50, 60. However, the length of the delay line can be significantly shorter since it needs only to be about as long as the temporal coherence length of the input beam 40. Also, for the case of an etalon spectrometer 190, no additional imaging would be necessary since the slight increase in beam size through the homogenizing optics, e.g., prisms 20, 50, 60 would not have a significant effect.

As shown in FIG. 1, following the beam splitter 90 could be the homogenizing prism 40. This optic could have multiple designs. One design, as discussed above, could use two dove prisms 22, 24 mounted together at their bases 26. In between the two prisms 22, 24 could be a partial reflecting coating. The dove prisms 22, 24 would produce two beams 32, 34 shown schematically in FIG. 1, from the original input beam 40. One, e.g., 32 would be the same orientation of the input beam 40 and the other 34 would be inverted. If the prism 20 were to be rotated, e.g., by 45 degrees about its optical axis, it would produce an inverted beam, e.g., 32 and a 90 degree rotated beam 34 from the original beam 40.

Also as shown in FIG. 1, after the homogenizing prism 40, could be two essentially totally reflective mirrors 90, 94, orientated to redirect the beam 32,34 to the beam splitter 90 for recombination with the portion of the input beam 40 initially reflected by the beam splitter 90. It will be understood that a small portion of the beam 32, 34 would be reflected back into the circuit with the main beam 40 and the process would repeat itself, even
further enhancing the homogenization process, e.g., during a time period that a photo-diode array ("PDA") 180 photo-diode pixels are integrating intensity values, e.g., for measuring the fringes created by the etalon spectrometer ("wavemeter") 190.

A second variant shown schematically in FIG. 2 could require a polarizing beam splitter 100. In this arrangement of FIG. 2, e.g., a ¹A wave plate 102 could be located after the polarizing beam splitter 100. The beam 40 could then be converted from linear to circular polarization by the ¹A wave plate 102. Next the beam 40 with its new polarization could be directed to the homogenizing prism 50. In this case the prism 50 could be a right angle prism 50 with a partial reflective coating on its hypotenuse face 52. The beam 40 could be incident upon the hypotenuse face 52 of the prism 50 where a portion could be reflected and a portion could be transmitted. The reflected portions of the beam 32, 34, including that reflected and flipped in the prism 50 by the reflective coatings on the faces 54, 56, could then travel back through the ¹A wave plate 102 and be converted back to linear polarization but rotated 90 degrees from the original input beam 40. Thus the homogenized beam 32, 34 would be transmitted by the polarizing beam splitter 100. The portion of the beam 40 that was transmitted by the hypotenuse face 52 of the homogenizing prism 50 would be directed to its right angle faces 54, 56 and would flip upon reflection. After reflection the beam 32, 34 would be directed to the hypotenuse face 52 again where a portion would be transmitted. The transmitted portion would follow the same path as the originally reflected beam and be transmitted by the polarizing beam splitter 102 to form output beam 40'. The reflected portion would repeat the flipping process where portions of it would be transmitted into the prism 50 and then reflected at the hypotenuse face 52 back again to the right angle faces 54, 56, again enhancing the homogenization process, e.g., during the integration of intensity levels at the PDA 180 photo-diode pixels. It will be understood that the apex angles of the faces can be selected to produce given deflections.

Applicants have also discovered during the development a better ways to quickly and effectively and consistently monitor E95 for purposes of on-board wavemeter determinations of that value, e.g., in laser output beams, e.g., in high repetition rate gas discharge laser systems, e.g., utilizing estimations from measurements of FWHM or the like. For a stationary interference pattern induced through diffusion of very narrow band spatially coherent laser light with sufficient coherence length, a so-called speckle pattern adds optical noise to the attempts to measure fringe values. Therefore, e.g., due to illumination with the relatively high-spatial-coherence light from, e.g., an XLA-100 ArF
MOPA configured two chamber gas discharge laser manufactured and sold by applicants' assignee, the introduction of repeatable changes in the measured FWHM or E95 of an etalon spectrometer such as 190 shown in FIG. 5 as a function of fringe position, has been observed, even at constant input bandwidth. This is believed to be at least in part because the speckle modulates the fringe pattern as a function of position when it is imaged in the detector plane at the PDA 180 shown in FIG. 5. Applicants have, therefore, devised an illumination arrangement for onboard bandwidth analysis systems, e.g., utilizing a PDA. The arrangements according to aspects of embodiments of the present invention are also to be understood, however, to be useful for spectrometry in general and for use, e.g., in initial testing in manufacturing or in field testing of bandwidth performance, of in spectrometer calibration, to provide, e.g., a temporally average image which greatly reduces adverse influence on the measured width of the fringe. This thereby suppresses the influence of speckle on the fringe width measurement, thereby reducing the uncertainty or error in bandwidth measurements using this technique. Of particular importance, challenges faced in implementing an E95 -monitor for high repetition rate gas discharge lithography light source lasers, which are becoming increasingly a demand of, e.g., makers of stepper/scanners for integrated circuit lithography, are more easily addressed. Indeed such high speed E95 meters to be effective with the necessary accuracies at the required resolution (e.g., at about the +/-15-20 fm level) need such a coherence destroying and speckle reducing apparatus.

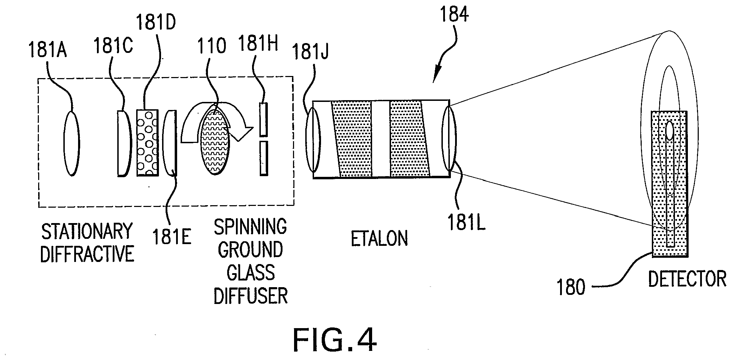

According to an aspect of an embodiment of the present invention standard XLA-100 spectral analysis module ("SAM") wavemeter being sold by applicants' assignee, containing an enhanced illumination system, e.g., as shown in FIG. 5 is modified as shown schematically in FIG. 4, e.g., by replacing the stationary second stage diffuser 181G in FIG. 5 with a spinning diffuser element 110. As shown schematically in FIG. 4 the following elements are as shown in FIG. 5, wherein about 95% of the beam from a beam splitter 170 passes through another beam splitter 173, a lens 181 A, reflecting off mirror 18 IB, through a lens 181 C, a first stage diffractive diffuser 18 ID and another lens 18 IE to another beam splitter 18 IF. At beam splitter 18 IF the beam is split so that about 90 percent of the beam is directed to etalon 184 through a lens 181 J and 10 percent of the beam is directed to atomic wavelength reference unit 190 shown in FIG. 5. Lens 18 IE focuses the diffusing beam from diffractive diffuser 181D at two locations: at the front face
of spinning diffuser 110 on the path to etalon 184 and at an equidistance location 18 IP on the path to AWR unit 190.

It will be understood by those skilled in the art that the diffuser need not spin per se, but simply needs to move relative to the spot of light incident upon it. It could, therefore, with the same effect, be vibrated, translated in one axis or in two axes simultaneously or sequentiall. As an alternative, schemes could be implemented wherein the spot of light itself is translated relative to a stationary diffuser. In alternatives to the claimed invention, the term "spinning diffuser" as used in this application is intended to cover all of these forms of relative translation of the optically interactive relationship between the spot of light (e.g., an incident beam) and the diffuser.

Spinning the diffuser 110, e.g., a ground glass diffuser, made by a process of sanding the surface of an optical element with sandpaper as is done by applicant's assignee to create, e.g., part No. 103929, which is sold in wavemeters sold by applicants assignee as on-board wavelength and bandwidth metrology units, and which may also be etched, e.g., with ammonium bi-fluoride, as is done by applicants' assignee in creating part NO. 109984 also found in wavemeters sold by applicants' assignee, causes the speckle pattern to move in the far field. By time-averaging the movement of the speckle pattern, the influence of the speckle is reduced to nearly zero. This effect can be verified by scanning the wavelength of the laser (not shown) or the spacing of the etalon 184. At constant input bandwidth, the fringes have a much more constant width as a function of position on the detector 180, when the diffuser is spinning and the speckle pattern is time-averaged. If the motion of the diffuser is stopped, a repeatable pattern of fluctuations in the width of the fringe as a function of position on the detector reappears,

Applicants have therefore proposed an illumination for a spectrometer that makes the spatial dependence of speckle intensity time dependant, e.g., by introducing a time-dependent and/or a position dependent random modulation of the source wavefront via, e.g., the insertion of a spinning (moving) diffuser and/or a source light beam moving with respect to the diffuser. The instantaneous speckle intensity, therefore, is made to have a constant mean by a randomly varying position dependence and, therefore, the time average of the moving speckle pattern can be made spatially homogenous, i.e., a "flat field." In this manner according to aspects of an embodiment of the present invention the speckle modulation of the time-averaged image formed by this light can thereby be greatly suppressed, reducing, e.g., the uncertainty or error in measurements performed on the image, e.g., measurements impacted by speckle noise, e.g., measurements of the width of a
spectrometer fringe to determine the spectral bandwidth with a higher degree of accuracy and repeatability.

At constant input bandwidths according to aspects of an embodiment of t4he present invention applicants have determined that the fringes have a width that, accounting for the dispersive properties of the bandwidth detection instrument being utilized, is constant even though their positions on the detector may be changing. These positions are a function of the wavelength of the illuminating spectrum and the dispersive properties of the instrument. Without a spinning diffuser as defined above, the image of the fringe can be modulated by a stationary speckle pattern, which can introduce an uncertainty r error into the fringe measurements of, e.g., intensity and/or width of the fringe image.

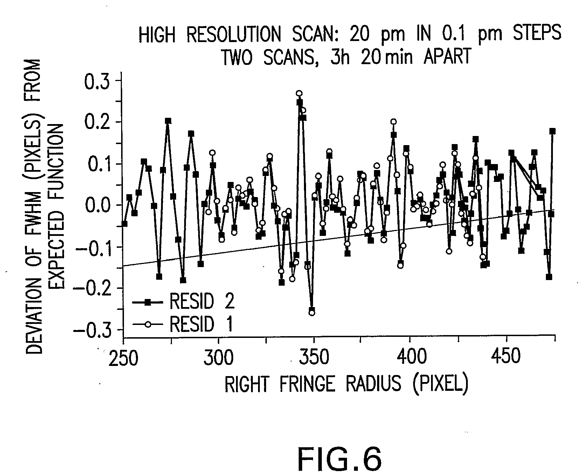

Turning now to FIG. 6 there is shown the a scan that illustrates the deviation of fringe measurements, e.g., at FWHM at the PDA 180 as a function of position of the right fringe radius at the pixel locations noted on the horizontal axis for two different scans varying wavelength of the source, taken several hours apart, but not long enough apart for the properties of the beam, e.g., spatial coherency, to have significantly changed, as the two scans show by virtual total agreement from scan to scan at the pixel locations. The modulation of width can be seen as the fringe is moved across the detector, e.g., a PDA, by the scanning of the source wavelength. Because the speckle pattern changes slowly, e.g., with time and as a function of wavelength, the speckle modulation of the image with position, e.g., lateral position on the PDA array of pixels, can be probed and determined as illustrated in FIG. 6.

The scans show significant deviations from the expected functions at the enumerated pixel locations, with maxima at around 0.25 pixels. This plot shows the large fluctuation in the FWHM of the etalon fringe as the laser wavelength is tuned across 20 pm. The fluctuations look random at first, but they are very repeatable as evidenced by the overlay of the patterns from the two runs, which are very similar even though they were performed more than 3 hours apart. The scans reflect an 800 pulse average across 4 bursts. This indicates that there can be very significant levels of noise, e.g., where through interpolation the software for current wavemeters of assignee seeks to differentiate fringe widths down to the 1/16^{th} of a pixel.

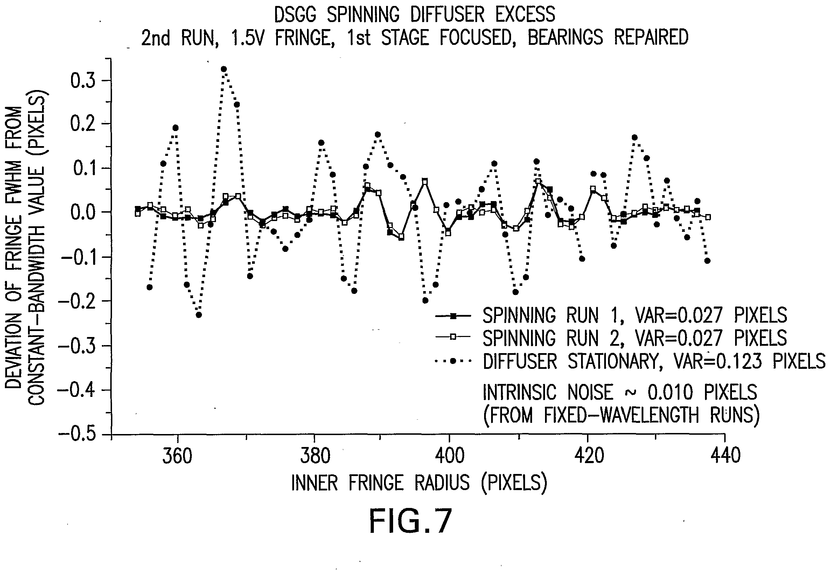

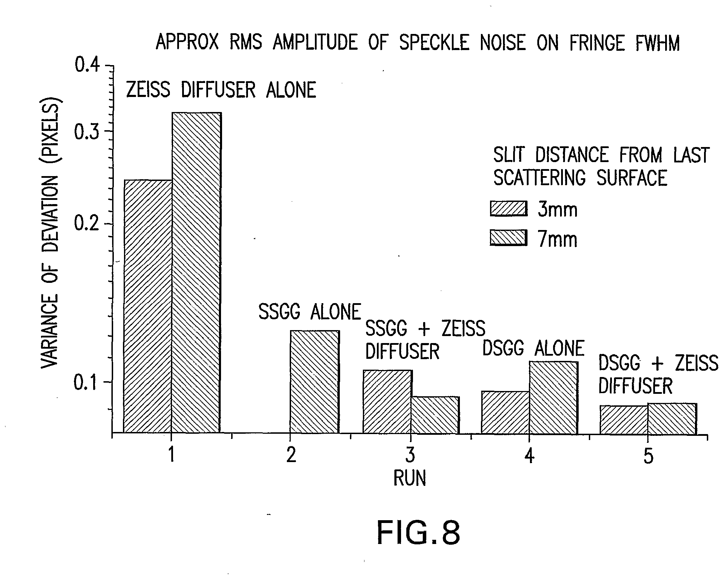

Turning to FIG. 7 there is shown an expanded view along the horizontal axis of one of the runs shown in FIG. 6, along with two runs with a spinning diffuser, e.g., a double sided ground glass ("DSGG") spinning diffuser. It can be seen that the spinning diffuser significantly decreases the deviations down from a variance of 0.123 pixels to 0.027 an almost one order of magnitude decrease which for the above stated reasons is of great significance. FIG. 7 shows that when a spinning or moving diffuser 110 is added, the noise can be significantly reduced. With the spinning diffuser, as defined above, the image is time-averaged and the variation of the measured fringe width with position is greatly suppressed as shown in FIG. 7. The hollow and filled square plots are with the diffuser 110 spinning, and the circle data point plot is with the diffuser 110 stationary. In this case, the effect is suppressed 2.6 times more than it was in the best case shown in the FIG. 8 discussed below. This is more than 12 times better than the worst case in that plot, also an 800 pulse average across 4 bursts.

FIG. 8 shows that for different kinds of diffusers and different arrangements of the illuminator slit, the amplitude of the fluctuation such as shown in FIG. 6 can be suppressed somewhat. The Zeiss diffuser is not a ground glass diffuser and is not spinning. The SSGG is a single sided ground glass diffuser and the DSGG is a double sided ground glass diffuser. The fluctuations, however, cannot be suppressed to the level needed for accurate measurements, however, without using a spinning diffuser or some other beam homogenization to remove, e.g., speckle effects.

Applicants also propose an arrangement according to aspects of an embodiment of the present invention which can provide a measurement value that should more accurately and consistently correlate with the E95 spectral width. The device could be made relatively very compact, e.g., as compared to the wavemeters as shown in FIG. 5. The apparatus, schematically illustrated in Fig.'s 9 and 10 would require only a single element detector 120, which could eliminate the complexity of a photodiode array 180 and its associated electronics. Also, because of the optical layout, the device 120 can use the full luminosity of its etalon 130. This feature in conjunction with the fact that the detector 122, e.g., which could be a photomultiplier tube (not shown) would significantly reduce the amount of light needed, thereby improving the lifetime of the etalon 130.

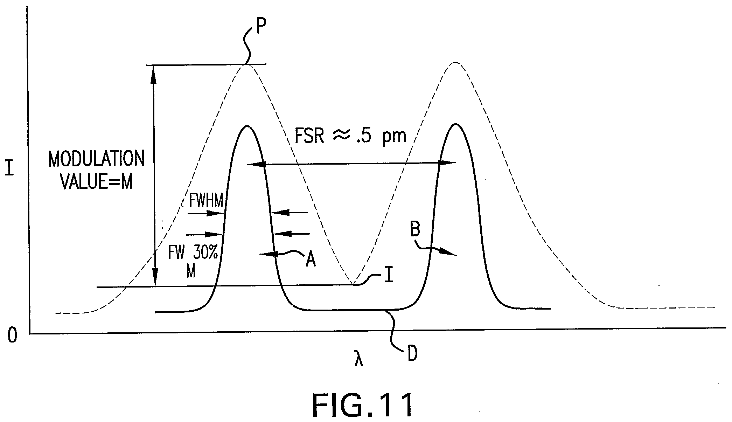

The apparatus according to aspects of an embodiment of the present invention may utilize, e.g., a diffusion section 132 that could, e.g., scramble any spatial-spectral relationships of the laser beam. The next part of the optical system in the path of the beam 40 to the etalon 130 could be a collimator 134 to collimate the diffused beam. The collimation optic 134 can be simple since the optical requirements for a 6mm diameter, diffraction limited beam are not demanding. The next section following the collimation portion 134 could be the etalon 130 which may be a confocal etalon 130 having a free spectral range ("FSR") equal to, e.g., the approximate E95 value of the source laser beam 40. as shown in FIG. 11, contrary to the current utilization of fringe pattern generating spectrometers, e.g., parallel plate etalons, the FSR is selected to induce overlapping of the convolved spectra output from the wavemeter, rather than strictly avoiding any such overlap. In the present application, therefore, the term approximately equal to the convolved bandwidth means that the FSR of the confocal etalon is close enough to the convolved spectrum output from the confocal etalon so as to induce this overlap sufficiently above the dark line of the slit function of the confocal etalon itself to enable accurate detection of that intersection I.

For the next generation, e.g., XLA-200 series lasers upcoming from applicants' assignee, the FSR could be about 0.5pm. At this small FSR value the use of a confocal etalon becomes almost a practical necessity. Given a wavelength of 193nm, e.g., for an ArF gas discharge laser system, e.g., in a MOPA configuration and an FSR of 0.5pm, the gap distance for an air spaced confocal etalon could be as much as 18.68mm, i.e., about 0.75 inches. The confocal etalon 130 should have superior geometric finesse over a parallel plate etalon, e.g., 184 as shown in FIG. 5. Also, given a radius of curvature of, e.g., 18.68mm, the maximum incident angle for an oscillating beam with a diameter of 6mm would be less than 10 degrees. This would enable the use of more standard high reflectivity ("HR") ArF coatings since they will not experience any significant change in reflectivity for incident angles less than 13 degrees.

Immediately following the etalon 130 according to aspects of an embodiment of the present invention could be the detector section 122. Since the etalon 130 will be used with a collimated input, no fringe imaging optics would be required. This eliminates the need for long focal length systems that can be subject to alignment problems and require significant space. All that would be required between the etalon 130 and the detector 122 would be, e.g., an aperture 140 to eliminate stray light. The detector 122 could receive the full output beam of the etalon 130 not just a linear section as in previous etalon spectrometer designs such as shown in FIG. 5. Therefore, the full luminosity of the etalon 130 can be used.

To measure, e.g., the E95 of the input light 40, the etalon 130 or the source 40 will need to be scanned. The etalon 122 can be scanned by physically changing the gap distance between the confocal reflectors 132, 134or by changing the pressure of the gas medium in between these mirrors 134, 136. according to an aspect of an embodiment of the present invention a more convenient way of scanning can be scan the wavelength of the source 40 or the angle of incidence of the source beam 40, as discussed in more detail below. This would eliminate the necessity for any moving parts in the E95 monitor. After the etalon 130 or source 40 is scanned, a modulation value can be calculated from the output signal of the detector 122, as illustrated in FIG. 11. This modulation value M, as shown in FIG 11 to be the difference between a peak value of a convolved fringe peak value P and an intersection value I where the convolved intensity curves for adjacent peaks A and B intersect due to the small FSR compared to, e.g., the FWHM or the FW at 30% Max ("FW30M") bandwidths for the source fringe peaks A and B, should correlate more to the magnitude of the E95 of the source 40. An actual E95 measurement can be generated using similar calibration techniques as are discussed in the above referenced co-pending patent applications assigned to applicants' assignee to, e.g., generate pre-determined relationship between the modulation value as measure by the output of the detector 122 and actual known E95 values from known spectra, e.g., as determined in the calibration process with, e.g., an LTB spectrometer.

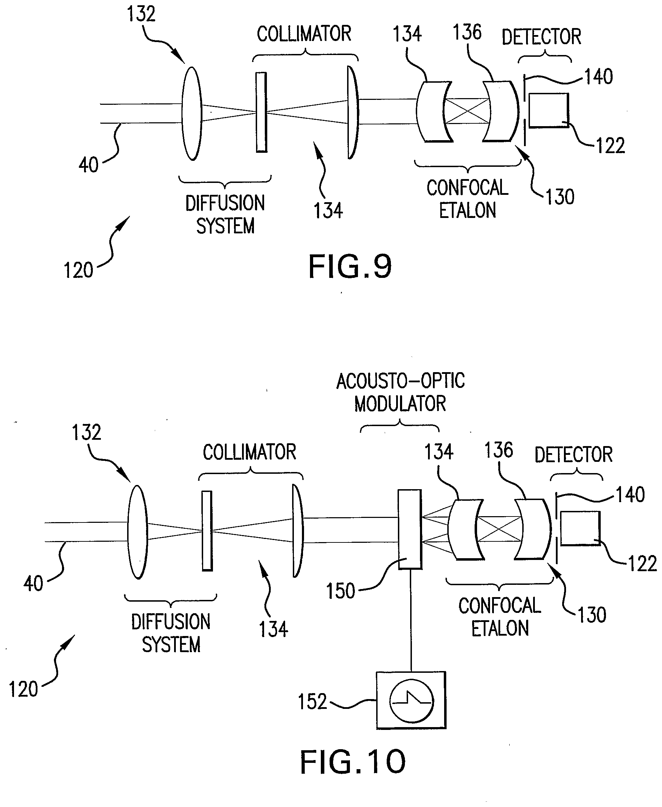

According to an aspect of an embodiment of the present invention illustrated schematically in FIG 10, the source beam 40 may be scanned spatially and, therefore, also angularly, across the etalon 130, e.g., by the use of an acousto-optical element 150, e.g., an acousto-optical modulator or beam deflector, which may also be stimulated by acoustic waves that are in a stepped modulation of a ramped modulation as delivered by a modulation source 152. This modulation of the acousto-optical element 150 can deliver a scanned source 40 to the etalon 130 at a plurality of discreet angles, or at a continuous scan of increasing or decreasing angles at some ramp function. No moving parts are required according to aspects of this embodiment of the present invention and the scan rates can be extremely fast. Known acousto-optical modulators are capable of scan rates in the MHz range and can be applied to, e.g., accommodate laser pulse repetition rate dependent scanning.

According to aspects of an embodiment of the present invention the acousto-optical modulator 150 could provide the scanning mechanism for the etalon 130, e.g., with a chirp signal provided to the modulator 150 to scan the etalon 130 over the angular range that would cover the FSR of the etalon 130. The acousto-optic modulator 150 could be located as close to the entrance of the etalon 130 as possible to mitigate vignetting by the aperture inside the etalon 130, e.g., 181K as shown in the etalon embodiment of FIG. 5.

According to aspects of an embodiment of the present invention to measure the E95 of the input light 40, the etalon 130 can be scanned by the acousto-optical modulator through at least an entire FSR. After the etalon is scanned, the above noted modulation value calculated from the detector signal can be generated. This modulation value should correlate to the magnitude of the E95 of the source. An actual E95 measurement can then be generated as discussed above.

The devices 120 shown in FIG.' s 9 and 10 could also be used to measure FWHM. The FWHM measurement could utilize a dark signal D between shots for a baseline. The FWHM would be measured relative to the peak signal as determined by the dark baseline. Other measurements, e.g., FW30M are also possible according to aspects of an embodiment of the present invention.

According to aspects of an embodiment of the present invention the destruction of spatial coherence in the beam, e.g., for use in measuring bandwidth and like metrology, this technique is equally applicable in the measurement of bandwidth with more accurate and also bulkier and more expensive grating spectrometers. For reasons of cost and bulkiness, such grating spectrometers (not shown) are not well adapted for on-board wavemeters of the type discussed above and are more used in the laboratory and in manufacturing, e.g., for quality control metrology and calibration tasks. However, the improvements to on-board spectrometry for laser wavemeters as discussed above according to aspects of embodiments of the present invention are equally applicable to improvement the measurements obtainable from other spectrometry metrology tools, e.g., grating spectrometers.

It will be understood by those skilled in the art that the aspects of the disclosed embodiments of the present invention can be varied from the specific embodiments disclosed. In operation, the beam homogenization apparatus and methods discussed above can be implemented in the laser output pulse beam path, e.g., at the output of the laser, e.g., the output of a PA chamber in a MOPA single or dual chamber configuration as such configurations are known in the art. This could be implemented in a beam delivery unit including, e.g., downstream of any pulse stretcher unit employed, in order to, e.g., even further reduce beam spatial coherency, e.g., to further reduce speckle effects. Moreover, these apparatus and methods may be used in the beam path within metrology tools, e.g., at the output of a MO chamber, the output of a PA chamber and even in any beam delivery unit, e.g., in a beam analysis module at the exit from the beam delivery unit and entrance to a lithography tool. As used herein, therefore, the term beam path includes any portion of the path of the pulses of laser light as such pulses are being generated, e.g., between an oscillator chamber and its associated line narrowing module or within the line narrowing module itself as such line narrowing modules are known in the art, at the exit of a laser chamber, including between, e.g., an MO and PA in a multi-medium laser configuration, including e.g., dual chambered MOPA configurations, and further in any beam delivery unit ("BDU") in the beam path to the ultimate destination of a UV-light-using tool. Similarly, while prism based beam homogenizers have been disclosed, other forms of optical beam homogenization can be employed as will be understood by those skilled in the art to carry out the purposes and intentions of aspects of embodiments of the present invention, and the term beam homogenizer will be understood to cover the embodiments disclosed and such other homogenizers. Homogenization may be carries out in multiple axes, e.g., horizontal and vertical and may be conducted along with rotational homogenization, as discussed above, and the term beam homogenizer should be interpreted to incorporate these aspects of homogenization as well. The homogenizer can be in the laser system itself upstream of any beam delivery unit or in a beam delivery unit intermediate the laser light source and a light using tool.

It is also well known that so-called wavemeters for the types of equipment with which aspects of embodiments of the present invention are used to measure such things as bandwidth and center wavelength, especially in regard to bandwidth, are subject to measuring errors. Especially this is so for on-board metrology tools, i.e., pulse energy and wavelength and bandwidth detectors where, e.g., the etalon or other dispersive optical element, e.g., a grating, has a so-called slit function that convolves with the source spectrum and must be deconvolved, actually or by some estimations and calculations as is known in the art. However, the resulting determination of, e.g., bandwidth per se is only an estimated bandwidth. Therefore the terms bandwidth and bandwidth measurement and bandwidth detection as used herein should take into account these aspects of, e.g., bandwidth determinations, particularly with on-board wavemeters as are known in the art. Wavemeters can be considered to be limited to on-board wavelength, bandwidth and pulse energy detectors as are known in the art, and not, e.g., more accurate spectrometers, e.g., used in laboratories and in manufacturing, e.g., for calibration purposes. However, as used in the present application wavemeter means all forms of spectral and center wavelength metrology tools wherein beam characteristics, e.g., spatial coherency as discussed above, can impact the accuracy of the metrology tool measurements and ultimate output representative of the estimation of, e.g., bandwidth for which the tool is employed and according to how it operates. These can include, e.g., all types of imaging spectrometers, e.g., grating spectrometers, e.g., ELIAS spectrometers made by LTB and utilized, e.g., for laser initial test in manufacturing, field testing of bandwidth performance and other like laboratory testing. It will also be understood that the term source beam as used in the present application means both the laser output beam itself and any portion thereof, e.g., diverted into an on-board, in-BDU or laboratory/manufacturing metrology tool for analysis. It will be understood also that, as discussed above, the homogenization of the beam is not for purposes of pulse stretching, especially in metrology uses of aspects of embodiments of the present invention. The temporal coherency length is important and the optical delay paths discussed above are at least that but only need to be in that range, and not the much longer delays for pulse stretching as discussed for example in above referenced co-pending applications and the 6,535,531 patent referenced above, and approximately the dame delay as the temporal coherence length shall have this meaning as used in the present application. It will also be understood as is well known in the art that fully or maximally reflecting surfaces have some absorption occurring therein within the limitations of the reflecting surfaces, especially with optical elements having coatings to tune the reflectivity, e.g., for a range of desired wavelengths, and that the terms fully reflective or reflecting or maximally reflective or reflecting means as fully or maximally reflective as can be achieved with a given selection of material, coating, type of optical element, etc. but not necessarily 100% reflective.

It will also be understood that while pulse stretchers as have been described above and in the above referenced patents and application using imaging mirrors can serve to invert the beam and thus reduce speckle, the specific applications of this phenomenon disclosed in the present application involve optics with are either fully transmissive, e.g., the dove prisms disclosed above, which themselves are partially reflective at the prism interface or prisms which transmit the beam partly, i.e., at lease internally to there be reflected by the totally reflecting side walls, as distinguished from convex mirrors used in pulse stretchers, and the term transmissive, as used in this application is intended to distinguish the homogenizers disclosed in the present application from convex imaging mirrors.

## Claims

1. A high repetition rate gas discharge laser lithography light source comprising a bandwidth detector for measuring the bandwidths of an output laser beam, the bandwidth detector comprising:
an optical spectrometer (190) and
a beam path leading to the optical spectrometer;
the beam path comprising a beam homogenizer, whereby the beam homogenizer comprises in the following order a first lens (181A), a second lens (181C), a stationary diffractive diffuser (181D), a third lens (181E), a rotating diffuser (110), and an aperture (181H), wherein the third lens focuses the diffused beam from the stationary diffractive diffuser (181D) at the front face of the rotating diffuser (110), and
wherein the spectrometer comprises a fourth lens (181J), an etalon (184), a fifth lens (181L) and a photo-diode array (180) being adapted to integrate intensity values for measuring the fringes created by the etalon and to time average the speckle pattern of the laser.

2. The high repetition rate gas discharge laser lithography light source of claim 1, wherein the beam homogenizer comprises at least one spatial coherency cell position shifter and a delay path, which is longer than, but approximately the same as the temporal coherence length of the source beam (40).

3. The high repetition rate gas discharge laser lithography light source of claim 1, wherein the rotating diffuser comprises a ground glass diffuser.

## Patentansprüche

1. Gasentladungslaser-Lithographie-Lichtquelle mit hoher Wiederholrate, umfassend einen Bandbreitendetektor zum Messen der Bandbreiten eines Ausgangslaserstrahls, wobei der Bandbreitendetektor umfasst:
ein optisches Spektrometer (190) und
einen Strahlenpfad, der zum optischen Spektrometer führt;
wobei der Strahlenpfad einen Strahlenhomogenisierer umfasst, wobei der Strahlenhomogenisierer in der folgenden Reihenfolge eine erste Linse (181A), eine zweite Linse (181C), einen stationären diffraktiven Diffusor (181D), eine dritte Linse (181E), einen rotierenden Diffusor (110) und eine Öffnung (181H) umfasst, wobei die dritte Linse den diffusen Strahl aus dem stationären diffraktiven Diffusor (181D) an der Vorderseite des rotierenden Diffusors (110) fokussiert, und
wobei das Spektrometer eine vierte Linse (181J), ein Etalon (184), eine fünfte Linse (181L) und eine Fotodiodenanordnung (180) umfasst, die angepasst sind, um Intensitätswerte zum Messen der durch den Etalon erzeugten Streifen und zum zeitlichen Mitteln des Speckle-Musters des Lasers zu integrieren.

2. Gasentladungslaser-Lithographie-Lichtquelle mit hoher Wiederholrate nach Anspruch 1, wobei der Strahlenhomogenisierer mindestens einen räumlichen Kohärenzzellenpositionsverschieber und einen Verzögerungspfad umfasst, der länger als, aber ungefähr gleich der zeitlichen Kohärenzlänge des Ausgangsstrahls (40) ist.

3. Gasentladungslaser-Lithographie-Lichtquelle mit hoher Wiederholrate nach Anspruch 1, wobei der rotierende Diffusor einen Milchglasdiffusor umfasst.

## Revendications

1. Source de lumière de lithographie laser à décharge gazeuse à taux élevé de répétition comprenant un détecteur de largeur de bande destiné à mesurer les largeurs de bande d'un faisceau laser de sortie, le détecteur de largeur de bande comprenant :
un spectromètre optique (190), et
un trajet de faisceau conduisant au spectromètre optique,
le trajet de faisceau comprenant un dispositif d'homogénéisation de faisceau, grâce à quoi le dispositif d'homogénéisation de faisceau comprend, dans l'ordre suivant : une première lentille (181A), une deuxième lentille (181C), un diffuseur diffractant fixe (181D), une troisième lentille (181E), un diffuseur tournant (110) et une ouverture (181H), la troisième lentille focalisant le faisceau diffusé provenant du diffuseur diffractant fixe (181D) au niveau de la face avant du diffuseur tournant (110), et
dans lequel le spectromètre comprend une quatrième lentille (181J), un étalon (184), une cinquième lentille (181L) et un réseau de photodiodes conçus pour intégrer les valeurs d'intensité permettant de mesurer les franges créées par l'étalon et pour élaborer la moyenne dans le temps du motif de tavelures du laser.

2. Source de lumière de lithographie laser à décharge gazeuse à taux élevé de répétition selon la revendication 1, dans laquelle le dispositif d'homogénéisation de faisceau comprend au moins un dispositif de décalage de position de cellule à cohérence spatiale et un trajet de retard qui est plus long que la longueur de cohérence dans le temps du faisceau source (40), mais qui est approximativement identique à celle-ci.

3. Source de lumière de lithographie laser à décharge gazeuse à taux élevé de répétition selon la revendication 1, dans lequel diffuseur tournant comprend un diffuseur en verre dépoli.
